# EUROPEAN PATENT SPECIFICATION

(11) **EP 2 309 832 B1**
(45) Date of publication and mention of the grant of the patent: **03.12.2014**
(21) Application number: 09799943.7
(22) Date of filing: 03.03.2009
(51) Int. Cl.: H05K 7/12, H05K 7/20, H05K 5/02

(54) **MOUNTING COMPONENTS, A MAIN FASTENER, AND AN ASSEMBLED STRUCTURE CONSISTING OF MOUNTING COMPONENTS AND COMMUNICATION EQUIPMENTS**
MONTAGEBAUTEILE, HAUPTBEFESTIGUNGSTEIL SOWIE ZUSAMMENGESETZTE STRUKTUR AUS DEN MONTAGEBAUTEILEN UND KOMMUNIKATIONSGERÄTEN
COMPOSANTS DE MONTAGE, UNE PIÈCE DE FIXATION PRINCIPALE ET UNE STRUCTURE ASSEMBLÉE COMPOSÉE DE COMPOSANTS DE MONTAGE ET D ÉQUIPEMENTS DE COMMUNICATION

(30) Priority: 25.07.2008 CN 200810144512
(43) Date of publication of application: 13.04.2011
(60) Divisional application: 12160665.1
(73) Proprietor: Huawei Technologies Co., Ltd., Longgang District, Shenzhen Guangdong 518129 (CN)
(72) Inventor: LIU, Changlin, Longgang District 518129, Shenzhen (CN); DENG, Shunqing, Longgang District 518129, Shenzhen (CN); LIU, Zhongxin, Longgang District 518129, Shenzhen (CN)
(74) Representative: Kreuz, Georg Maria
(86) International application number: PCT/CN2009/070610
(87) International publication number: WO 2010/009627

(56) References cited:
- WO-A1-2004/105261
- CN-Y- 2 674 802
- CN-Y- 2 674 802
- CN-Y- 2 886 004
- CN-Y- 2 901 503
- CN-Y- 201 097 472
- CN-Y- 201 184 339
- FR-A1- 2 371 749
- FR-A1- 2 371 749
- JP-A- 2005 286 086
- JP-A- 2005 286 086

## Description

### FIELD OF THE TECHNOLOGY

The present invention relates to the field of communication technology, and more particularly to a mounting component, and an assembly of a mounting component.

### BACKGROUND OF THE INVENTION

In the prior art, in order to meet the demands of different mounting/erecting configurations and scenarios in sites, a Radio Remote Unit (RRU) is required to be mounted to have a flexibly assembled structure which can be mounted and maintained separately. In addition, the mounting of the RRU requires the consistent arrangement of a mounting component and accessories thereof, so as to decrease the operability of each stage throughout the whole process, reduce the waste of the materials, and thus save the cost throughout the whole process.

In the prior art, a mounting structure adapted to mount an RRU is typically an assembly mounting of a machine frame and a mounting backplate, in which the mounting backplate is fixed on a mounting place (for example, a wall), the machine frame is mounted on the mounting place, and an RRU is inserted in the fixed machine frame and tightened, and finally a plastic shell against solar radiation is covered thereon. The steps for mounting the RRU in the prior art are as follows.

In Step 1, a mounting backplate is fixed on a wall with expansion bolts.

In Step 2, a machine frame is placed on the mounting backplate and fixed thereto.

In Step 3, an RRU is inserted in the fixed machine frame.

In Step 4, the mounting of the RRU is completed.

In Step 5, a plastic shell is mounted.

In Step 6, the plastic shell is fixed.

The prior art has at least the following disadvantages:
As the RRU is mounted using the assembly mounting of the machine frame and the mounting backplate, the mounting steps of the RRU are complicated and have low flexibility.
WO 2004/105261 discloses a housing apparatus of an out-door communication device for receiving electronic parts for communication and thermal-emission devices. The housing apparatus for an outdoor communication device includes a housing that receives electronic parts for communication and thermal-emission device therein. The housing is coupled to an external column by a plurality of mounting brackets and screws.
FR 2371749 discloses a case for devices such as those used in the fields of telecommunications and measurement.

### SUMMARY OF THE INVENTION

The present invention is directed to a mounting component for mounting communication equipment, more specially, an assembly of a mounting component, so as to simplify the mounting process.

A mounting component for mounting communication equipment is provided, which includes a buckling member and an auxiliary member.

The buckling member and the auxiliary member are cooperatively fixed on a fixture.

The buckling member has a connecting portion for interlocking a retaining member of the communication equipment.

The connecting portion is a dovetail.

A main fastener is provided, which includes a front side, a rear side, a left side, and a right side. A clamp portion of the main fastener is disposed at the front side, and a connecting portion for interlocking a retaining member of communication equipment is disposed at the rear side. The connecting portion is a dovetail.

An assembly of a mounting component as disclosed above is provided, which further includes communication equipment and a retaining member fixed on the communication equipment. The connecting portion of the buckling member is interlocked with the retaining member of the communication equipment. The connecting portion is a dovetail.

It can be seen from the above technical solutions that, the connecting portion of the buckling member is interlocked with the retaining member of the communication equipment, such that the communication equipment is attached to the buckling member. This mounting process is easier and more flexible.

### BRIEF DESCRIPTION OF THE DRAWINGS

To illustrate the technical solutions according to the embodiments of the present invention or in the prior art more clearly, the accompanying drawings for describing the embodiments or the prior art are introduced briefly as follows. Obviously, the accompanying drawings in the following description are only some embodiments of the present invention.
FIG. 1 is a schematic structural view of a mounting component according to an embodiment of the present invention;
FIG. 2 is a schematic structural view of a main fastener according to a first embodiment of the present invention;
FIG. 3 is a schematic structural view of a main fastener according to the first embodiment of the present invention;
FIG. 4 is a schematic structural view of a main fastener according to the first embodiment of the present invention;
FIG. 5 is a schematic structural view of a main fastener having a screw with waisted shank according to the first embodiment of the present invention;
FIG. 6 is a schematic structural view of a screw with waisted shank according to an embodiment of the present invention;
FIG. 7 is a cross-sectional view of a waisted shank structure according to the first embodiment of the present invention;
FIG. 8 is a schematic structural view of a mounting component according to a second embodiment of the present invention;
FIG. 9 is a schematic structural view of a retaining member of an RRU according to an embodiment of the present invention;
FIG. 10 is a schematic view of mounting a mounting component according to an embodiment of the present invention;
FIG. 11 is a schematic view of mounting a mounting component according to an embodiment of the present invention;
FIG. 12 is a schematic view of mounting an RRU according to an embodiment of the present invention;
FIG. 13 is a diagram showing a mounting result of an RRU according to an embodiment of the present invention;
FIG. 14 is a schematic view of connecting a plurality of main fasteners according to an embodiment of the present invention;
FIG. 15 is a schematic view of connecting a plurality of main fasteners according to an embodiment of the present invention;
FIG. 16 is a schematic view of mounting RRUs at a single side of a plurality of main fasteners according to an embodiment of the present invention;
FIG. 17 is a schematic view of centralized mounting effect of RRUs at a single side according to an embodiment of the present invention; and
FIG. 18 is a schematic view of centralized mounting effect of RRUs at both sides according to an embodiment of the present invention.

### DETAILED DESCRIPTION OF THE EMBODIMENTS

The technical solution of the present invention will be clearly and completely described as follows accompanying with the drawings. It is obvious that the embodiments to be described are only a part rather than all of the embodiments of the present invention.

In an embodiment, the present invention provides a mounting component for mounting communication equipment, which includes a buckling member and an auxiliary member. The buckling member and the auxiliary member are cooperatively fixed on a fixture. The buckling member has a connecting portion for interlocking a retaining member of the communication equipment.

It can be seen from the above that, the mounting component according to the embodiment of the present invention is interlocked with the retaining member of the communication equipment through the connecting portion of the buckling member, such that the communication equipment is attached to the buckling member. This mounting process is easier and more flexible.

The connecting portion may be a dovetail.

The communication equipment may be an RRU.

The fixture may be a holding pole or an angle steel.

Hereinafter, descriptions are made with the connecting portion as a dovetail.

### First Embodiment

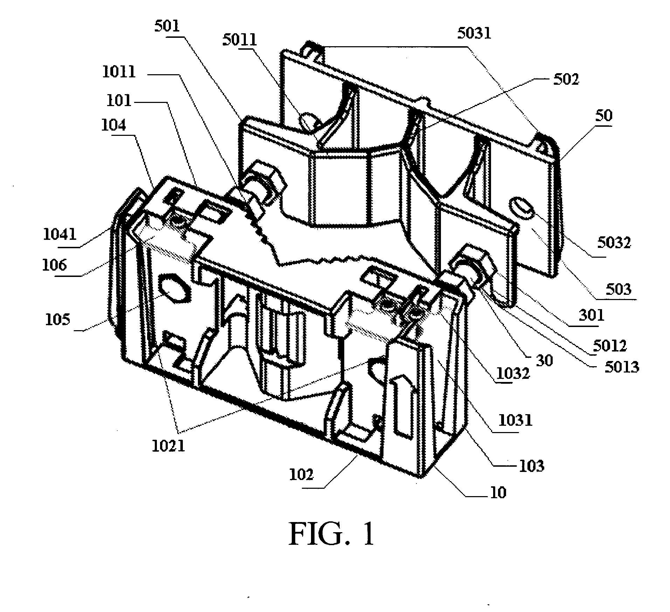

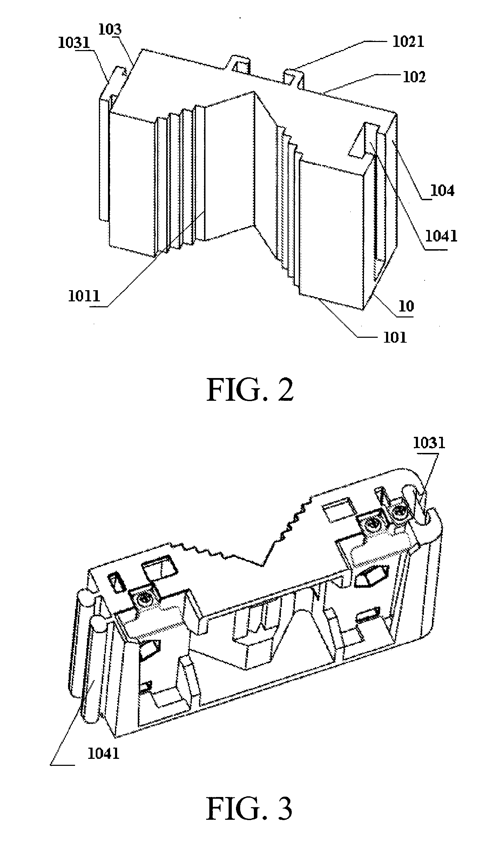

FIGs. 1 and 2 are schematic structural views of a mounting component for mounting communication equipment according to an embodiment of the present invention. Referring to FIGs. 1 and 2, a buckling member includes a main fastener 10 and long protruding portions 30. The main fastener 10 has four sides, that is, a front side 101, a rear side 102, a left side 103, and a right side 104.

A clamp portion 1011 of the main fastener is formed at the front side 101 of the main fastener, and a dovetail 1021 is disposed on a side opposite to the clamp portion 1011 of the main fastener, that is, disposed on the rear side 102 of the main fastener. A first buckling portion 1031 is disposed at the left side 103 of the main fastener, and a second buckling portion 1041 is disposed at the right side 104 of the main fastener. The first buckling portion 1031 is interlocked with a second buckling portion at a right side of another main fastener, and the second buckling portion 1041 is interlocked with a first buckling portion at a left side of another main fastener.

It can be seen from the above that, the main fastener of the mounting component according to the embodiment of the present invention is interlocked with the retaining member fixed on the communication equipment through the dovetail, such that the communication equipment communication equipment is attached to the main fastener. This mounting process is easier and more flexible.

It can be understood that structure of the other main fasteners may be the same as that of the main fastener 10, and the first buckling portion of the other main fasteners may be interlocked with the second buckling portion of the main fastener 10; or the second buckling portion of the other main fasteners may be interlocked with the first buckling portion of the main fastener 10. In this manner, the dovetail of the other main fasteners may be interlocked with the retaining member of another communication equipment, and thus the communication equipment is attached to the other main fasteners.

The dovetail 1021 disposed at the rear side 102 of the main fastener may be a female dovetail groove or a male dovetail.

The first buckling portion 1031 may be a male dovetail, and the second buckling portion 1041 may be a female dovetail groove. Alternatively, the first buckling portion 1031 may be a female dovetail groove, and the second buckling portion 1041 may be a male dovetail.

Further, a blade spring 1032 may be disposed at an upper edge of the buckling portion that is configured as a female dovetail groove, such that the blade spring 1032 is pressed against a step-like structure of a male dovetail of another main fastener, when the female dovetail groove of the buckling portion is interlocked with the male dovetail of the another main fastener.

The first buckling portion 1031 and the second buckling portion 1041 may alternatively be as shown in FIG. 3. In FIG. 3, the first buckling portion 1031 may be a cylindrical groove, and the second buckling portion 1041 may be a cylindrical protrusion. The structure of another main fastener is the same as that of the main fastener 10, as such, the cylindrical groove of the main fastener 10 may be interlocked with a cylindrical protrusion of the another main fastener, and the cylindrical protrusion of the main fastener 10 may be interlocked with a cylindrical groove of the another main fastener.

Further, long protruding portions 30 are disposed at the front side 101 of the main fastener and at both sides of the clamp portion 1011 of the main fastener.

Referring to FIG. 2 again, the dovetail 1021 disposed at the rear side 102 of the main fastener may be one, and located at nearly a central position of the rear side 102 of the main fastener. The dovetail may be a male dovetail or a female dovetail groove.

Alternatively, the dovetails 1021 disposed on the rear side 102 of the main fastener may be two, and respectively located at both sides of the rear side 102 of the main fastener.

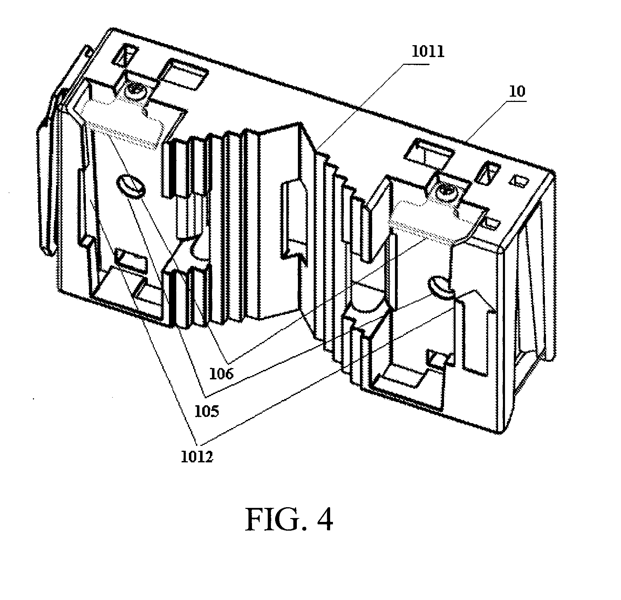

Referring to FIG. 4, furthermore, dovetails 1012 are disposed at the front side 101 of the main fastener and at both sides of the clamp portion 1011 of the main fastener. For facilitating the assembly of an RRUs, the sizes of the retaining members of the RRUs may be the same, the position of the dovetail at the front side 101 of the main fastener is required to be opposite to the position of the dovetail at the rear side 102 of the main fastener (not shown in FIG. 4). The dovetail at the front side 101 of the main fastener may be a female dovetail groove or a male dovetail.

Referring to FIGs. 1 and 4, the long protruding portions 30 may be long bolts, and holes 105 are opened extending through the front side 101 of the main fastener and the rear side 102 of the main fastener. The holes 105 may extend through the dovetail at the front side 101 of the main fastener and the dovetail at the rear side 102 of the main fastener. The long bolts pass through the holes 105, and are fixed on the main fastener 10.

Referring to FIG. 1 again, one end of the hole 105 is a hexagonal counterbore (not shown) having a diameter larger than that of the hole 105. A nut that mates with the hexagonal counter bore to prevent the long bolt from rotating is disposed at one end of the long bolt, thereby securing the long bolt to the main fastener 10.

In addition, referring to FIG. 4, if the dovetail at the front side or the rear side of the main fastener is a female dovetail groove, and a blade spring 106 is disposed on the upper edge of the female dovetail groove. When the female dovetail groove is interlocked with the male dovetail on the retaining member of the RRU, the blade spring 106 is pressed against a step-like structure of the male dovetail.

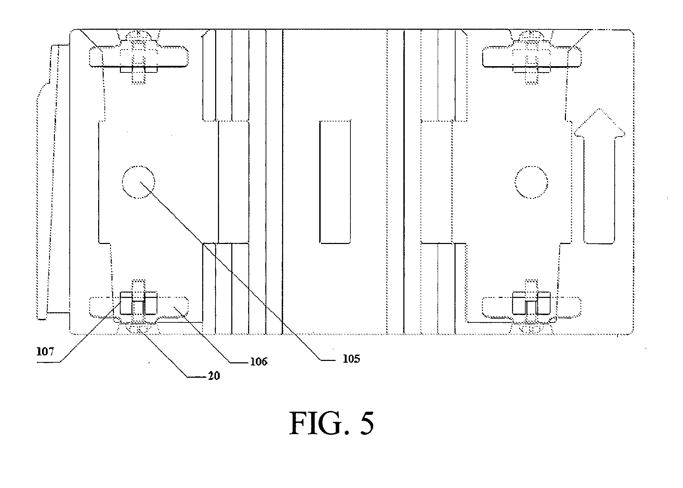

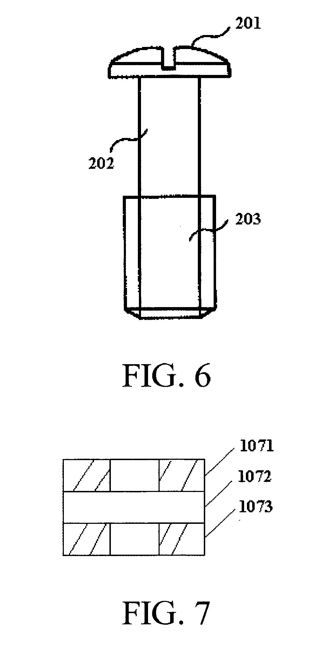

Referring to FIG. 5, for the disposition of the blade spring 106 on the female dovetail groove, the blade spring 106 may be attached to the upper edge of the female dovetail groove by using a waisted shank bolt 20. The structure of the waisted shank bolt is shown in FIG. 6, which includes a nut cap 201, a shank 202, and a threaded portion 203, and the diameter of the shank 202 is smaller than the inner diameter of the threaded portion 203. Correspondingly, a structure with waisted shank 107 is formed at an upper portion of the female dovetail groove of the main fastener. A cross-sectional view of the structure with waisted shank 107 is shown in FIG. 7, which includes a threaded portion 1071, an unthreaded portion 1072, and a lower threaded portion 1073, and the unthreaded portion 1072 may be a square hole.

Specifically, the waisted shank bolt 20, the structure with waisted shank 107, and the blade spring 106 of the main fastener is collected in the following way. The waisted shank bolt 20 passes through the blade spring, with the threaded portion 203 screwed in the lower threaded portion 1073 of the structure with waisted shank 107, such that the blade spring of the main fastener is in a tightened state. When an RRU needs to be fixed, the blade spring of the main fastener presses against a step-like structure of a male dovetail on a retaining member of the RRU. The waisted shank bolt 20 is screwed upward, the blade spring of the main fastener is drooped when the threaded portion 203 is screwed out from the lower threaded portion 1073 of the structure with waisted shank 107 to the unthreaded portion 1072, and then the RRU is taken out.

Referring to FIG. 1 again, an auxiliary member of the mounting component for mounting the communication equipment according to the embodiment of the present invention is an auxiliary fastener 50, which includes a front portion 501, a middle portion 502, and a rear portion 503. The front portion 501 is connected to the rear portion 503 through the middle portion 502. An auxiliary clamp portion 5011 is opened at nearly a central position of the front portion 501 of the auxiliary fastener 50, and notches 5012 are defined at the front portion of the auxiliary fastener located at both sides of the auxiliary clamp portion 5011 in which one end of the notches 5012 is unclosed.

In addition, a dovetail 5031 is disposed at the rear portion 503 of the auxiliary fastener 50 for interlocking the dovetail at the front side 101 of the main fastener.

Further, holes 5032 are defined in the rear portion 503 of the auxiliary fastener 50, and configured corresponding to the holes 105.

It can be understood that the dovetail 5031 at the rear portion 503 of the auxiliary fastener 50 may be a male dovetail, and correspondingly, the dovetail at the front side 101 of the main fastener may be a female dovetail groove; and the dovetail 5031 at the rear portion 503 of the auxiliary fastener 50 may be a female dovetail groove, and correspondingly, the dovetail at the front side 101 of the main fastener may be a male dovetail.

Referring to FIG. 1 again, the long protruding portions 30, the main fastener 10, and the auxiliary fastener 50 are assembled as follows.

One end of the long protruding portion 30 passes through the hole 105 of the main fastener 10 and is fixed on the main fastener 10, and the other end of the long protruding portion 30 is interlocked with the notch 5012 of the auxiliary fastener 50 and is fixed through a nut, as such the long protruding portion 30, the main fastener 10, and the auxiliary fastener 50 are assembled as a whole.

In order to ensure long protruding portion 30 to be well fixed in the notch 5012, a blade spring 5013 is arranged at an opening of the notch 5012 of the auxiliary fastener 50, and the blade spring is fixed on the auxiliary fastener 50 with a screw, such that the blade spring 5013 is pressed against the long protruding portion 30.

Further, the long protruding portion 30 is sleeved with a joint nut 301. The middle portion of the joint nut 301 of the long protruding portion 30 is an intermediate connecting portion of the joint nut 301 and received in notch 5012. The joint nut 301 is tightened to fix the main fastener 10 and the auxiliary fastener 50. The blade spring 5013 is pressed against the intermediate connecting portion of the joint nut sleeved on the long protruding portion.

In addition, the long protruding portion 30 may be a long bolt with a nut disposed at one end, and the nut mates with the hexagonal counter bore at one end of the hole 105, so as to fix the long bolt and the main fastener 10.

Further, the other end of the long protruding portion 30 passes through the hole 5032 of the auxiliary fastener, and is fixed by a fixing member such as a nut.

### Second Embodiment

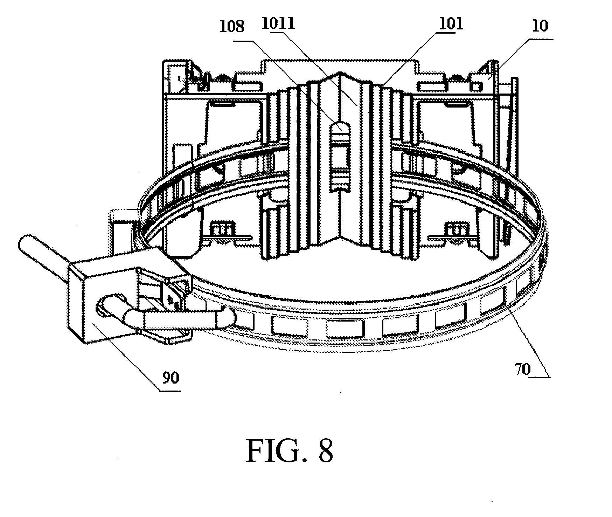

FIG. 8 is a schematic structural view of a mounting component according to an embodiment of the present invention. As shown in FIG. 8, an auxiliary member may be an auxiliary strip 70. The mounting component includes a buckling member and the auxiliary strip 70. The buckling member includes a main fastener.

The distinction between the main fastener of this embodiment and the main fastener 10 of the first embodiment is that, at a front side 101 of the main fastener, for example, in a clamp portion 1011 of the main fastener, a through hole 108 is defined, the width of the through hole matches with that of the auxiliary strip 70, so that the auxiliary strip 70 can pass through the through hole 108 and be fixed on the main fastener 10.

The auxiliary strip 70 may be a steel strip.

The main fastener and the auxiliary strip 70 are assembled as follows.

The auxiliary strip 70 passes through the through hole 108 and is fixed on the main fastener 10. The auxiliary strip 70 is fixed on a fixture through a locker 90.

The fixture may be a holding pole or an angle steel.

It should be noted that the main fastener in the second embodiment may have a structure similar to the main fastener 10 in the first embodiment, for example, a dovetail 1021 is formed at a rear side 102 of the main fastener, and is interlocked with a retaining member fixed on communication equipment. The structure of the main fastener will not be detailed herein again.

It can be seen from the above that, the main fastener of the mounting component according to the embodiment of the present invention is interlocked with the retaining member of the communication equipment through the dovetail, such that the communication equipment is attached to the main fastener. This mounting process is easier and more flexible.

The mounting component for mounting the communication equipment according to the embodiment of the present invention is described above, and the retaining member fixed on the communication equipment (that is, the retaining member of the communication equipment) is described in the following.

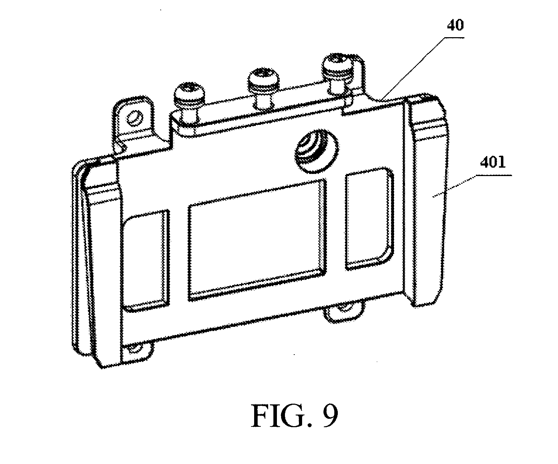

FIG. 9 is a schematic structural view of a retaining member 40 fixed on the communication equipment according to the embodiment of the present invention. A dovetail 401 is disposed at one side of the retaining member 40, and fixed on the communication equipment with a screw.

The communication equipment may be an RRU.

The dovetail 401 may be a female dovetail groove or a male dovetail.

Referring to FIG. 9 again, the retaining member is fixed on the communication equipment with a screw. Specifically, two holes are respectively defined in the retaining member 40 and the communication equipment, and a screw passes through the hole in the retaining member and the hole in the communication equipment to fix the retaining member 40 on the communication equipment.

### Third Embodiment

In this embodiment, the present invention provides an assembly of a mounting component, which further includes the communication equipment, a retaining member fixed on the communication equipment, a buckling member, and an auxiliary member. The buckling member is interlocked with the auxiliary member, and is fixed on a fixture. The buckling member has a connecting portion for interlocking the retaining member of the communication equipment.

It can be seen from the above that, as for the assembly of the mounting component according to the embodiment of the present invention, the communication equipment is attached to the buckling member easily by interlocking the connecting portion of the buckling member with the retaining member of the communication equipment. This mounting process is easier and more flexible.

Further, the buckling member includes a main fastener and long protruding portions. The auxiliary member is an auxiliary fastener. A front side of the main fastener and/or a front portion of the auxiliary fastener has a clamp portion for clasping the fixture, and the long protruding portions protrude from both sides of the front side of the main fastener and are retained in notches in the front portion of the auxiliary fastener. The structure of the mounting component is similar to that in the above embodiment, and the details may not be described herein again.

Further, the buckling member is a main fastener, and the auxiliary member is an auxiliary strip. A front side of the main fastener has a through hole, and the width of the through hole matches with that of the auxiliary strip so that the auxiliary strip can pass through the through hole and to be fixed on the main fastener. The structure of the mounting component is similar to that in the above embodiment, and the details may not be described herein again.

It should be noted that in the assembly of the mounting component according to the embodiment of the present invention, the structures of the buckling member, the auxiliary member, and the retaining member of the communication equipment are the same as those of the buckling member, the auxiliary member, and the retaining member of the communication equipment in the above embodiments, and no more details will be given again.

An example is given below for illustration, in which the communication equipment is an RRU, and the installation of one or a plurality of RRUs will be described respectively as follows.

### Mounting of one RRU

The RRU may be mounted by using the mounting component of the first embodiment in the following manner.

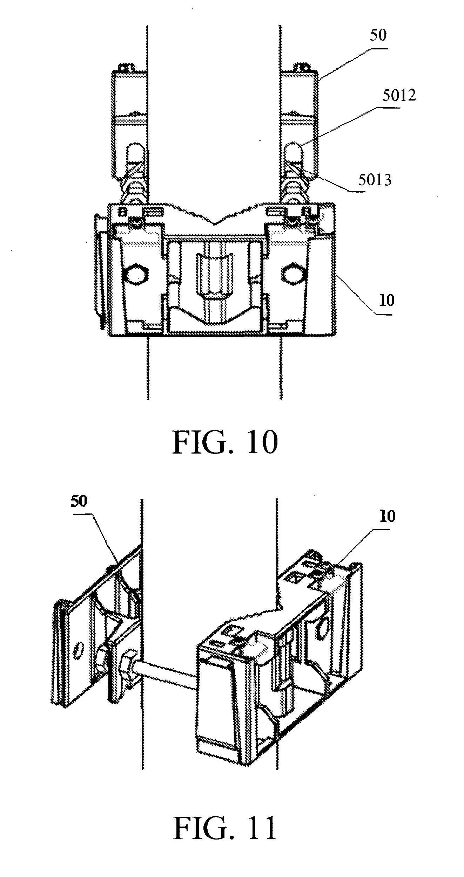

Referring to FIGs. 1, 10, and 11, the clamp portion 1011 of the main fastener is attached to a holding pole or an angle steel. Then, the notches 5012 of the auxiliary fastener 50 retains the intermediate connecting portions of the joint nuts 301 sleeved on the long bolts protruding from both sides of the clamp portion 1011 of the main fastener, such that the blade springs 5013 of the auxiliary fastener press against the intermediate connecting portions of the joint nuts 301. Next, the joint nuts 301 are tightened, to secure the main fastener 10 and the auxiliary fastener 50 on the holding pole or the angle steel. If the width of the holding pole or the angle steel is too small, the long bolts 30 pass through the notches 5012 and then through the holes 5032, so as to make the mounting component firmly attached to the holding pole or the angle steel.

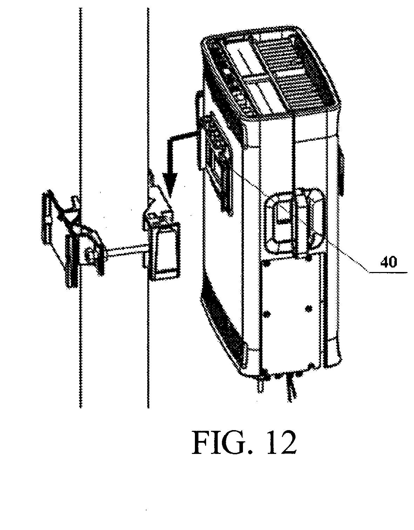

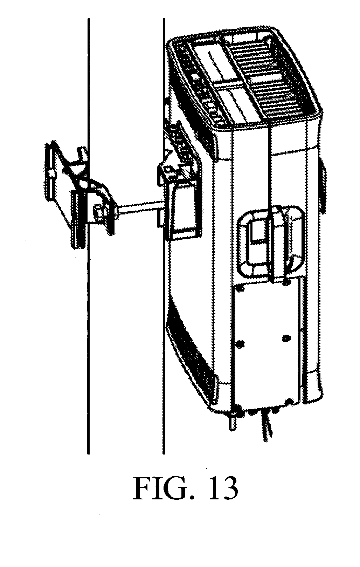

Referring to FIGs. 1, 9, 12, and 13, the dovetail 401 at the retaining member of the RRU is interlocked with the dovetail 1021 at the rear side 102 of the main fastener. If the dovetail 401 at the retaining member of the RRU is a male dovetail, and the dovetail 1021 at the rear side 102 of the main fastener is a female dovetail groove, the blade springs 106 of the main fastener at the upper edge of the female dovetail groove press against the step-like structure of the male dovetail on the retaining member, so as to prevent the retaining member of the RRU from falling off.

In the embodiment of the present invention, the long bolts protruding from the front side of the main fastener are retained in the notches in the front portion of the auxiliary fastener, to fix the main fastener and the auxiliary fastener on a fixture such as a holding pole or an angle steel. Then, the dovetail at the rear side of the main fastener is interlocked with the dovetail on the retaining member of the RRU, such that the RRU is fixed on the mounting component. The whole mounting process has fewer steps and is simple. Besides, the mounting component achieves the purpose of fixing the RRU only by using the main fastener and the auxiliary fastener, and thus the cost of the mounting component is lowered.

Referring to FIGs. 1, 8, and 9, the RRU may be mounted using the mounting component of the second embodiment in the following manner.

Firstly, the auxiliary strip 70 passes through the through hole 108 in the main fastener, and is fixed on the main fastener 10. Then, the auxiliary strip 70 is fixed on a holding pole or an angle steel through the locker 90.

Next, the dovetail 401 at the retaining member of the RRU is interlocked with the dovetail 1021 at the rear side 102 of the main fastener. If the dovetail 401 at the retaining member of the RRU is a male dovetail, and the dovetail 1021 at the rear side 102 of the main fastener is a female dovetail groove, the blade springs 106 of the main fastener at the upper edge of the female dovetail groove press against the step-like structure of the male dovetail on the retaining member, so as to prevent the retaining member of the RRU from falling off.

In the embodiment of the present invention, the main fastener and the auxiliary strip 70 are fixed in the through hole 108 of the main fastener, and then the auxiliary strip 70 is fixed on the holding pole or the angle steel. Then, the dovetail at the rear side of the main fastener is interlocked with the dovetail on the retaining member of the RRU, such that the RRU is fixed on the mounting component. The whole mounting process has fewer steps and is simple. Besides, the mounting component achieves the purpose of fixing the communication equipment only by using the main fastener and the auxiliary strip, and thus the cost of the mounting component is lowered.

Mounting of a plurality of RRUs at a single side of a holding pole or an angle steel

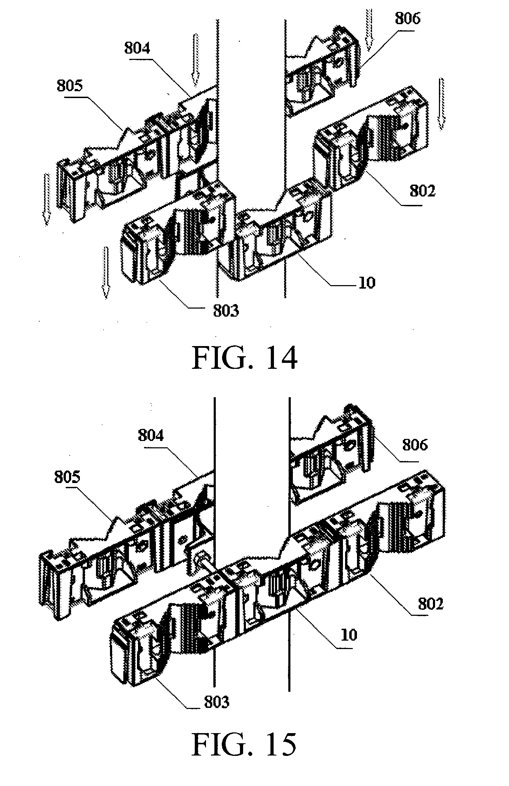

Referring to FIGs. 1, 14, and 15, the mounting manner of a single RRU is the same as the above, and in the case that a plurality of RRUs, for example, three RRUs, needs to be mounted at a single side of a holding pole or an angle steel, the main fastener having a clamp portion attached to the angle steel is a first main fastener 10, the structure of which is similar to that in the first embodiment, so the details may not be described herein again. A first buckling portion 1031 of the first main fastener 10 is interlocked with a second buckling portion of a second main fastener 802, and a second buckling portion 1041 of the first main fastener is interlocked with a first buckling portion of a third main fastener 803. A dovetail at a rear side of the first main fastener 10 is interlocked with a retaining member of the RRU, and dovetails at front sides of the second main fastener 802 and the third main fastener 803 are respectively interlocked with retaining members of the RRUs.

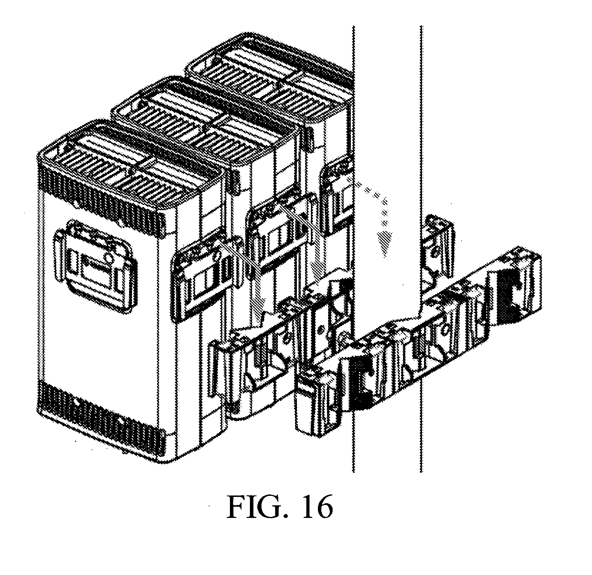

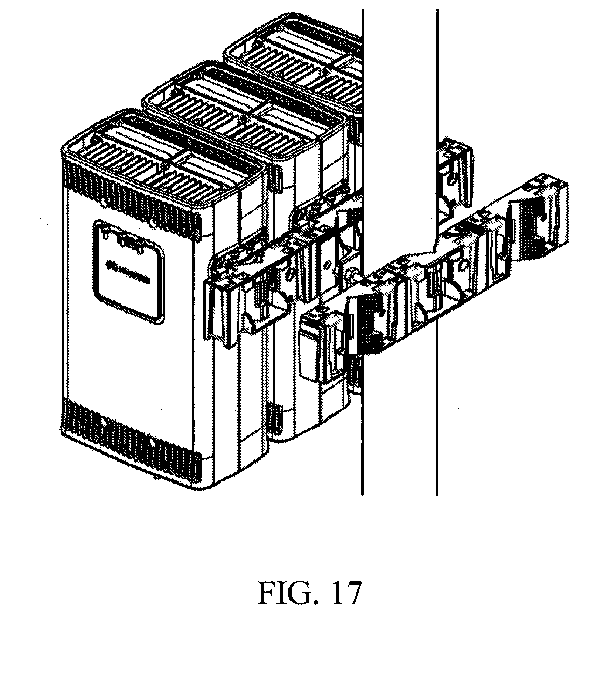

Definitely, the RRU may also be mounted by attaching the auxiliary fastener to the main fastener at one side. At one side of the auxiliary fastener 50, the auxiliary fastener 50 is fixed on a fourth main fastener 804 by interlocking the dovetail at the rear portion of the auxiliary fastener with a dovetail at a front side of the fourth main fastener 804. A first buckling portion of the fourth main fastener 804 is interlocked with a second buckling portion of a fifth main fastener 805, and a second buckling portion of the fourth main fastener 804 is interlocked with a first buckling portion of a sixth main fastener 806. A dovetail at a rear side of the fourth main fastener 804 is interlocked with the retaining member of the RRU, and dovetails at front sides of the fifth main fastener 805 and the sixth main fastener 806 are interlocked with the retaining members of the RRUs. The mounting step of the RRUs is shown in FIG. 16, and the mounting result is shown in FIG. 17.

Mounting of a plurality of RRUs at opposite sides of a holding pole or an angle steel

Referring to FIGs. 1, 14, and 15, it is assumed that three RRUs are required to be respectively mounted at opposite sides of a holding pole or an angle steel, and in this case, the main fastener having a clamp portion attached to the angle steel is a first main fastener 10, the structure of which is similar to that in the first embodiment, so the details may not be described herein again. A first buckling portion 1031 of the first main fastener 10 is interlocked with a second buckling portion of a second main fastener 802, and a second buckling portion 1041 of the first main fastener is interlocked with a first buckling portion of a third main fastener 803. A dovetail at a rear side of the first main fastener 10 is interlocked with a retaining member of the RRU, and dovetails at front sides of the second main fastener 802 and the third main fastener 803 are interlocked with retaining members of the RRUs.

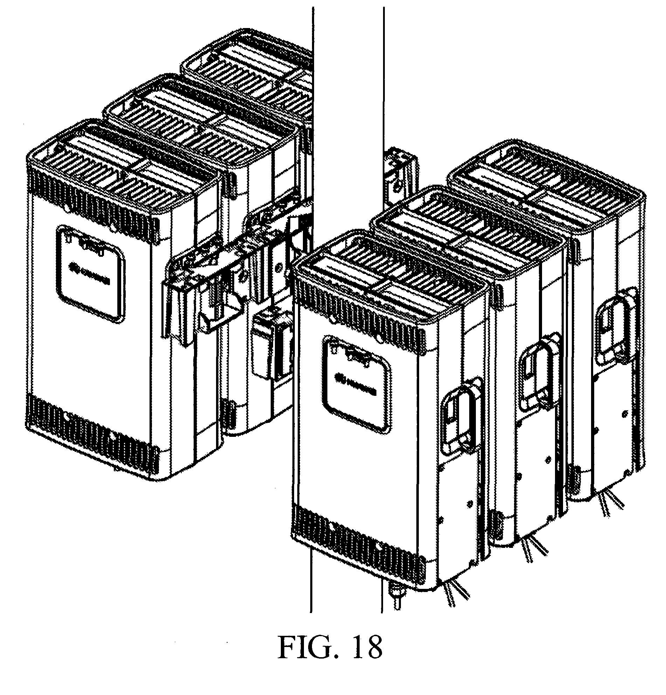

At one side of the auxiliary fastener 50, the auxiliary fastener 50 is fixed on a fourth main fastener 804 by interlocking the dovetail at the rear portion of the auxiliary fastener with a dovetail at a front side of the fourth main fastener 804. A first buckling portion of the fourth main fastener 804 is interlocked with a second buckling portion of a fifth main fastener 805, and a second buckling portion of the fourth main fastener 804 is interlocked with a first buckling portion of a sixth main fastener 806. A dovetail at a rear side of the fourth main fastener 804 is interlocked with the retaining member of the RRU, and dovetails at front sides of the fifth main fastener 805 and the sixth main fastener 806 are interlocked with the retaining members of the RRUs. The mounting result is shown in FIG. 18.

According to the embodiment of the present invention, the main fastener is interlocked with other main fasteners through the first buckling portion and/or the second buckling portion, and then the RRUs are mounted on the other main fasteners, so as to achieve the centralized mounting of the RRUs, and the mounting process of the RRUs is simple and practical.

The mounting component, the main fastener, and the assembly of the mounting component according to the embodiments of the present invention are described in detail above. The principle and implementation of the present invention are described herein through specific examples. The description about the embodiments of the present invention is merely provided for ease of understanding of the method and core ideas of the present invention. Therefore, the specification shall not be construed as a limit to the present invention.

## Claims

1. A mounting component for mounting a communication equipment, comprising a buckling member and an auxiliary member, wherein
the buckling member and the auxiliary member are cooperatively fixed on a fixture; and
the buckling member has a connecting portion for interlocking a retaining member (40) of the communication equipment;
wherein the mounting component is **characterized in that**:
the connecting portion is a dovetail (1021).

2. The mounting component according to claim 1, wherein the buckling member comprises a main fastener (10) and long protruding portions (30), and the auxiliary member is an auxiliary fastener (50); the main fastener (10) comprises a front side (101) and a rear side (102), and the front side (101) of the main fastener (10) and/or a front portion (501) of the auxiliary fastener (50) has a clamp portion (1011); the connecting portion of the main fastener (10) is disposed at the rear side (102) of the main fastener (10); the front portion (501) of the auxiliary fastener (50) is defined with notches (5012), and the long protruding portions (30) protrude from the front side (101) of the main fastener (10) and are retained in the notches (5012) at the front portion (501) of the auxiliary fastener(50).

3. The mounting component according to claim 2, wherein the long protruding portion (30) comprises a long bolt and a joint nut (301) screwed on the long bolt, and the notch (5012) of the auxiliary fastener (50) retains an intermediate connecting portion of the joint nut on the long bolt (30).

4. The mounting component according to claim 3, wherein a blade spring (5013) is arranged at an opening of the notch (5012) that is unclosed at one end, and the blade spring (5013) is pressed against the intermediate connecting portion of the joint nut (301) on the long bolt (30).

5. The mounting component according to claim 1, wherein the buckling member is a main fastener (10), and the auxiliary member is an auxiliary strip (70); the main fastener (10) comprises a front side (101) and a rear side (102), and the front side (101) of the main fastener (10) has a through hole (108); the width of the through hole (108) matches with that of the auxiliary strip (70), such that the auxiliary strip (70) is fixed on the main fastener (10) via the through hole (108); the connecting portion of the main fastener (10) is disposed at the rear side (102) of the main fastener (10).

6. The mounting component according to claim 2 or 5, wherein a dovetail (1021) is disposed at the rear side (102) or the sides of clamp portion (1011) on the front side (101) of the main fastener (10), and the dovetail (1021) at the rear side (102) of the main fastener (10) is interlocked with a dovetail (401) on the retaining member (40) of the communication equipment.

7. The mounting component according to claim 6, wherein a dovetail (5031) is formed at a rear portion (503) of the auxiliary fastener (50), and is interlocked with a dovetail (1021) at a front side (101) or a rear side (102) of another main fastener (10).

8. The mounting component according to claim 7, wherein the dovetail (1021) at the front side (101) or the rear side (102) of the main fastener (10) is a female dovetail groove, the female dovetail groove is disposed with a blade spring (106) at an upper edge, and the blade spring (106) presses against a step-like structure of a male dovetail interlocked with the female dovetail groove.

9. The mounting component according to claim 2 or 5, wherein holes (105) are opened extending through the front side (101) of the main fastener (10) and the rear side (102) of the main fastener (10).

10. The mounting component according to claim 2 or 5, wherein the main fastener (10) comprises a left side (103) and a right side (104); a first buckling portion (1031) is disposed at the left side (103) of the main fastener (10) and is interlocked with a second buckling portion (1041) at the right side (104) of another main fastener (10); and/or, a second buckling portion (1041) is disposed at the right side (104) of the main fastener (10) and is interlocked with a first buckling portion (1031) at the left side (103) of another main fastener (10).

11. An assembly of a mounting component according to claim 1, further comprising a communication equipment, and a retaining member (40) fixed on the communication equipment, wherein the connecting portion of the buckling member of the mounting component is interlocked with the retaining member (40) of the communication equipment.

12. The assembly of mounting component according to claim 11, wherein the buckling member comprises a main fastener (10) and long protruding portions (30), and the auxiliary member is an auxiliary fastener (50), a front side (101) of the main fastener (10) and/or a front portion (501) of the auxiliary fastener (50) has a clamp portion (1011, 5011), the front portion (501) of the auxiliary fastener (50) is opened with notches (5012), and the long protruding portions (30) protrude from the front side (101) of the main fastener (10) and are retained in the notches (5012) at the front portion (501) of the auxiliary fastener (50).

13. The assembly of mounting component according to claim 11, wherein the buckling member is a main fastener (10), and the auxiliary member is an auxiliary strip (70), a front side (101) of the main fastener (10) has a through hole (108), and the width of the through hole (108) matches with that of the auxiliary strip (70), such that the auxiliary strip (70) is fixed on the main fastener (10) via the through hole (108).

## Patentansprüche

1. Montagekomponente zum Montieren einer Kommunikationsvorrichtung, die ein Knickelement und ein Hilfselement umfasst, wobei
das Knickelement und das Hilfselement zusammenwirkend auf einer Befestigungseinrichtung befestigt sind; und
das Knickelement einen Verbindungsabschnitt zum Verriegeln eines Halteelements (40) der Kommunikationsvorrichtung aufweist;
wobei die Montagekomponente **dadurch gekennzeichnet ist, dass** der Verbindungsabschnitt ein Schwalbenschwanz (1021) ist.

2. Montagekomponente nach Anspruch 1, wobei das Knickelement ein Hauptbefestigungselement (10) und lange vorstehende Abschnitte (30) umfasst und das Hilfselement ein Hilfsverbindungselement (50) ist; das Hauptbefestigungselement (10) eine Vorderseite (101) und eine Rückseite (102) umfasst und die Vorderseite (101) des Hauptbefestigungselements (10) und/oder ein vorderer Abschnitt (501) des Hilfsverbindungselements (50) einen Klemmabschnitt (1011) aufweist; der Verbindungsabschnitt des Hauptbefestigungselements (10) an der Rückseite (102) des Hauptbefestigungselements (10) angeordnet ist; der vordere Abschnitt (501) des Hilfsverbindungselements (50) mit Aussparungen (5012) definiert ist, und die langen vorstehenden Abschnitte (30) aus der Vorderseite (101) des Hauptbefestigungselements (10) vorstehen und in die Aussparungen (5012) an dem vorderen Abschnitt (501) des Hilfsverbindungselements (50) aufgenommen sind.

3. Montagekomponente nach Anspruch 2, wobei der lange vorstehende Abschnitt (30) eine lange Schraube und eine Verbindungsmutter (301), die auf die lange Schraube geschraubt ist, umfasst und die Aussparung (5012) des Hilfsverbindungselements (50) einen Zwischenverbindungsabschnitt der Verbindungsmutter auf der langen Schraube (30) aufnimmt.

4. Montagekomponente nach Anspruch 3, wobei eine Blattfeder (5013) an einer Öffnung der Aussparung (5012), die an einem Ende unverschlossen ist, angeordnet ist und die Blattfeder (5013) gegen den Zwischenverbindungsabschnitt der Verbindungsmutter (301) auf der langen Schraube (30) gedrückt ist.

5. Montagekomponente nach Anspruch 1, wobei das Knickelement ein Hauptbefestigungselement (10) ist und das Hilfselement ein Hilfsband (70) ist; das Hauptbefestigungselement (10) eine Vorderseite (101) und eine Rückseite (102) umfasst, und die Vorderseite (101) des Hauptbefestigungselements (10) ein Durchgangsloch (108) aufweist; die Breite des Durchgangslochs (108) mit der des Hilfsbands (70) zusammenpasst, so dass das Hilfsband (70) über das Durchgangsloch (108) auf dem Hauptbefestigungselement (10) befestigt ist; der Verbindungsabschnitt des Hauptbefestigungselements (10) an der Rückseite (102) des Hauptbefestigungselements (10) angeordnet ist.

6. Montagekomponente nach Anspruch 2 oder 5, wobei ein Schwalbenschwanz (1021) an der Rückseite (102) oder den Seiten des Klemmabschnitts (1011) auf der Vorderseite (101) des Hauptbefestigungselements (10) angeordnet ist und der Schwalbenschwanz (1021) an der Rückseite (102) des Hauptbefestigungselements (10) mit einem Schwalbenschwanz (401) an dem Halteelement (40) der Kommunikationsvorrichtung in Eingriff ist.

7. Montagekomponente nach Anspruch 6, wobei ein Schwalbenschwanz (5031) an einem rückseitigen Abschnitt (503) des Hilfsverbindungselements (50) gebildet ist und in Eingriff mit einem Schwalbenschwanz (1021) an einer Vorderseite (101) oder einer Rückseite (102) eines weiteren Hauptbefestigungselements (10) ist.

8. Montagekomponente nach Anspruch 7, wobei der Schwalbenschwanz (1021) an der Vorderseite (101) oder der Rückseite (102) des Hauptbefestigungselements (10) eine weibliche Schwalbenschwanznut ist, wobei die weibliche Schwalbenschwanznut mit einer Blattfeder (106) an einer Oberkante angeordnet ist und die Blattfeder (106) gegen eine stufenartige Struktur eines männlichen Schwalbenschwanzes, der mit der weiblichen Schwalbenschwanznut in Eingriff ist, drückt.

9. Montagekomponente nach Anspruch 2 oder 5, wobei Löcher (105) geöffnet sind, die sich durch die Vorderseite (101) des Hauptbefestigungselements (10) und die Rückseite (102) des Hauptbefestigungselements (10) erstrecken.

10. Montagekomponente nach Anspruch 2 oder 5, wobei das Hauptbefestigungselement (10) eine linke Seite (103) und eine rechte Seite (104) umfasst; ein erster Knickabschnitt (1031) an der linken Seite (103) des Hauptbefestigungselements (10) angeordnet und in Eingriff mit einem zweiten Knickabschnitt (1041) an der rechten Seite (104) eines weiteren Hauptbefestigungselements (10) ist; und/oder ein zweiter Knickabschnitt (1041) an der rechten Seite (104) des Hauptbefestigungselements (10) angeordnet und in Eingriff mit einem ersten Knickabschnitt (1031) an der linken Seite (103) eines weiteren Hauptbefestigungselements (10) ist.

11. Anordnung einer Montagekomponente nach Anspruch 1, die ferner eine Kommunikationsvorrichtung und ein Halteelement (40), das auf der Kommunikationsvorrichtung befestigt ist, umfasst, wobei der Verbindungsabschnitt des Knickelements der Montagekomponente mit dem Halteelement (40) der Kommunikationsvorrichtung in Eingriff ist.

12. Anordnung der Montagekomponente nach Anspruch 11, wobei das Knickelement ein Hauptbefestigungselement (10) und lange vorstehende Abschnitte (30) aufweist und das Hilfselement ein Hilfsverbindungselement (50) ist, eine Vorderseite (101) des Hauptbefestigungselements (10) und/oder ein vorderer Abschnitt (501) des Hilfsverbindungselements (50) einen Klemmabschnitt (1011, 5011) aufweist, der vordere Abschnitt (501) des Hilfsverbindungselements (50) mit Aussparungen (5012) geöffnet ist und die langen vorstehenden Abschnitte (30) von der Vorderseite (101) des Hauptbefestigungselements (10) vorstehen und in die Aussparungen (5012) an dem vorderen Abschnitt (501) des Hilfsverbindungselements (50) aufgenommen sind.

13. Anordnung der Montagekomponente nach Anspruch 11, wobei das Knickelement ein Hauptbefestigungselement (10) ist und das Hilfselement ein Hilfsband (70) ist, eine Vorderseite (101) des Hauptbefestigungselements (10) ein Durchgangsloch (108) aufweist und die Breite des Durchgangslochs (108) mit der des Hilfsbandes (70) übereinstimmt, so dass das Hilfsband (70) auf dem Hauptbefestigungselement (10) über das Durchgangsloch (108) befestigt ist.

## Revendications

1. Composant de montage pour le montage d'un équipement de communication, comprenant un organe d'attache et un organe auxiliaire,
l'organe d'attache et l'organe auxiliaire étant fixés de manière coopérative sur une pièce fixe ; et
l'organe d'attache ayant une partie de connexion pour le verrouillage réciproque d'un organe de retenue (40) de l'équipement de communication ;
le composant de montage étant **caractérisé en ce que** :
la partie de connexion est une queue d'aronde (1021).

2. Composant de montage selon la revendication 1, dans lequel l'organe d'attache comprend une pièce de fixation principale (10) et des longues parties saillantes (30), et l'organe auxiliaire est une pièce de fixation auxiliaire (50) ; la pièce de fixation principale (10) comprenant un côté avant (101) et un côté arrière (102), et le côté avant (101) de la pièce de fixation principale (10) et/ou une partie avant (501) de la pièce de fixation auxiliaire (50) ayant une partie de serrage (1011) ; la partie de connexion de la pièce de fixation principale (10) est disposée au niveau du côté arrière (102) de la pièce de fixation principale (10) ; la partie avant (501) de la pièce de fixation auxiliaire (50) est définie avec des entailles (5012), et les longues parties saillantes (30) font saillie à partir du côté avant (101) de la pièce de fixation principale (10) et sont retenues dans les entailles (5012) au niveau de la partie avant (501) de la pièce de fixation auxiliaire (50).

3. Composant de montage selon la revendication 2, dans lequel la longue partie saillante (30) comprend un long boulon et un écrou d'assemblage (301) vissé sur le long boulon, et l'entaille (5012) de la pièce de fixation auxiliaire (50) retient une partie de connexion intermédiaire de l'écrou d'assemblage sur le long boulon (30).

4. Composant de montage selon la revendication 3, dans lequel un ressort à lame (5013) est agencé au niveau d'une ouverture de l'entaille (5012) qui n'est pas fermée à une extrémité, et le ressort à lame (5013) est pressé contre la partie de connexion intermédiaire de l'écrou d'assemblage (301) sur le long boulon (30).

5. Composant de montage selon la revendication 1, dans lequel l'organe d'attache est une pièce de fixation principale (10), et l'organe auxiliaire est une bande auxiliaire (70) ; la pièce de fixation principale (10) comprend un côté avant (101) et un côté arrière (102), et le côté avant (101) de la pièce de fixation principale (10) a un trou traversant (108) ; la largeur du trou traversant (108) correspond à celle de la bande auxiliaire (70), de telle sorte que la bande auxiliaire (70) soit fixée sur la pièce de fixation principale (10) via le trou traversant (108) ; la partie de connexion de la pièce de fixation principale (10) est disposée au niveau du côté arrière (102) de la pièce de fixation principale (10).

6. Composant de montage selon la revendication 2 ou 5, dans lequel une queue d'aronde (1021) est disposée au niveau du côté arrière (102) ou des côtés de la partie de serrage (1011) sur le côté avant (101) de la pièce de fixation principale (10), et la queue d'aronde (1021) au niveau du côté arrière (102) de la pièce de fixation principale (10) est verrouillée réciproquement avec une queue d'aronde (401) sur l'organe de retenue (40) de l'équipement de communication.

7. Composant de montage selon la revendication 6, dans lequel une queue d'aronde (5031) est formée au niveau d'une partie arrière (503) de la pièce de fixation auxiliaire (50), et est verrouillée réciproquement avec une queue d'aronde (1021) au niveau d'un côté avant (101) ou d'un côté arrière (102) d'une autre pièce de fixation principale (10).

8. Composant de montage selon la revendication 7, dans lequel la queue d'aronde (1021) au niveau du côté avant (101) ou du côté arrière (102) de la pièce de fixation principale (10) est une rainure de queue d'aronde femelle, la rainure de queue d'aronde femelle est disposée avec un ressort à lame (106) au niveau d'un bord supérieur, et le ressort à lame (106) presse contre une structure de type gradin d'une queue d'aronde mâle verrouillée réciproquement avec la rainure de queue d'aronde femelle.

9. Composant de montage selon la revendication 2 ou 5, dans lequel des trous (105) sont ouverts de manière à s'étendre à travers le côté avant (101) de la pièce de fixation principale (10) et le côté arrière (102) de la pièce de fixation principale (10).

10. Composant de montage selon la revendication 2 ou 5, dans lequel la pièce de fixation principale (10) comprend un côté gauche (103) et un côté droit (104) ; une première partie d'attache (1031) est disposée au niveau du côté gauche (103) de la pièce de fixation principale (10) et est verrouillée réciproquement avec une deuxième partie d'attache (1041) au niveau du côté droit (104) d'une autre pièce de fixation principale (10) ; et/ou une deuxième partie d'attache (1041) est disposée au niveau du côté droit (104) de la pièce de fixation principale (10) et est verrouillée réciproquement avec une première partie d'attache (1031) au niveau du côté gauche (103) d'une autre pièce de fixation principale (10).

11. Assemblage d'un composant de montage selon la revendication 1, comprenant en outre un équipement de communication et un organe de retenue (40) fixé sur l'équipement de communication, dans lequel la partie de connexion de l'organe d'attache du composant de montage est verrouillée réciproquement avec l'organe de retenue (40) de l'équipement de communication.

12. Assemblage d'un composant de montage selon la revendication 11, dans lequel l'organe d'attache comprend une pièce de fixation principale (10) et des longues parties saillantes (30), et l'organe auxiliaire est une pièce de fixation auxiliaire (50), un côté avant (101) de la pièce de fixation principale (10) et/ou une partie avant (501) de la pièce de fixation auxiliaire (50) a/ont une partie de serrage (1011, 5011), la partie avant (501) de la pièce de fixation auxiliaire (50) est définie avec des entailles (5012), et les longues parties saillantes (30) font saillie à partir du côté avant (101) de la pièce de fixation principale (10) et sont retenues dans les entailles (5012) au niveau de la partie avant (501) de la pièce de fixation auxiliaire (50).

13. Assemblage d'un composant de montage selon la revendication 11, dans lequel l'organe d'attache est une pièce de fixation principale (10), et l'organe auxiliaire est une bande auxiliaire (70), un côté avant (101) de la pièce de fixation principale (10) a un trou traversant (108), et la largeur du trou traversant (108) correspond à celle de la bande auxiliaire (70), de telle sorte que la bande auxiliaire (70) soit fixée sur la pièce de fixation principale (10) via le trou traversant (108).
